# EUROPEAN PATENT APPLICATION

(11) **EP 4 455 153 A1**
(43) Date of publication of application: **30.10.2024**
(21) Application number: 23461567.2
(22) Date of filing: 28.04.2023
(51) Int. Cl.: C07F 7/22, C07F 7/24, C01B 9/00, C01B 21/06, H10K 85/50, G01F 1/00

(54) **A METHOD FOR SYNTHESIZING HALIDE SALTS, A HALIDE SALT BASED PEROVSKITE INK AND POWDER AND A HALIDE SALT BASED PEROVSKITE**

(71) Applicant: Fundacja Saule Research Institute, 54-427 Wroclaw (PL)
(72) Inventor: PRZYPIS, Lukasz, 44-186 Gieraltowice (PL); ZURAW, Wiktor, 54-434 Wroclaw (PL)
(74) Representative: Kancelaria Eupatent.pl Sp. z.o.o

(57) **Abstract**

A method for synthesizing halide salts of a Formula Me^{y+}X⁻_{y}, wherein Me^{y+} represents a cation of a metal having a valency y, and X⁻ represents an anion of a halogen (X₂). The method comprises reacting a first reactant comprising the metal at a zero oxidation degree (Me⁰) in a powder form and an organic acid (A) in a solvent (S), wherein the molar ratio of the metal (Me⁰) to the organic acid (A) is in the range of 0.1:1.0 to 2.0:1.0 with a second reactant being a diatom halogen: X₂.

## Description

### TECHNICAL FIELD

The present invention relates to a method for synthesizing halide salts, a halide salt based perovskite ink and powder, and a halide salt based perovskite.

### BACKGROUND

Thin-film perovskite solar cells feature good efficiency and substantially low production costs. Unlike traditional silicon solar cells, thin-film perovskite solar cells can be deposited on flexible substrates, which makes them suitable for use in applications such as flexible and portable electronics, building-integrated photovoltaics, vehicles, etc.

Perovskites for perovskite solar cells (PSCs), such as ABXs-type perovskites, can be produced from suitable precursor compounds, including metal halide salts (MeX_{y}), such as SnI₂ and SnBr₂, PbI₂ or PbBr₂. The presence of impurities in the perovskite precursors, including metal halide salts MeX_{y}, where X typically represents I, Br or Cl, is highly undesired because the impurities can cause defects in formed perovskite material as well as influence perovskite film morphology, and/or contribute to forming recombination centers for charge carriers, thereby, reducing both efficiency and stability of PSCs. Among the impurities typically detected in the perovskite precursors, Sn^{IV} cations (Sn⁴⁺) - being a result of oxidation of tin perovskite precursors (SnX₂), is considered an inevitable severe drawback. For instance, even highly-pure SnI₂ such as that commercially available from Sigma-Aldrich or Alfa Aesar may contain a substantial amount of Sn⁴⁺. Moreover, batches of SnI₂ from the same provider can vary in purity resulting in big differences of photovoltaic efficiency of the PSCs comprising the perovskite formed using the precursors. Thereby, the oxidation of Sn²⁺ to Sn⁴⁺ can occur during both the preparation of perovskite precursor solutions and perovskite film fabrication, leading to inferior device reproducibility.

Certain impurities may be created further, in the perovskite matrix of the PSC, i.a. due to the oxidative acting of the environment oxygen molecules reach the perovskite material in the PSC.
For the reasons mentioned above, perovskite materials - including those based on metal halides, are prone to accelerated material degradation and reduced light absorption over a substantially short time in PSCs.

From the patent literature, there are known various attempts aiming at minimizing the presence of defects and impurities, such as tin (IV) cations, in the perovskite material and methods for preparing metal halides of improved purity to be used as perovskite precursors.

Chinese patent application CN112607765 describes a method for preparing stannous fluoride (SnF₂) employing the reaction of stannous oxide with hydrofluoric acid and freeze-drying treatment.

US patent application US20180282861 describes a method for preparing metal halide film capable of being converted into an organometal halide having a perovskite structure. The method consists in contacting a precursor film - i.e. an adduct layer, containing an adduct of metal halide - MX₂, wherein M is selected from Cu, Ni, Co, Fe, Mn, Cr, Pd, Cd, Ge, Sn, Pb, and Yb, and X stands for I, Br, or F, with a polar protic solvent - being alcohol-based solvent. The precursor film is formed by applying the adduct solution containing the metal halide and the guest molecule on a substrate; wherein the porous metal halide film is formed by contacting the precursor film with the polar protic solvent.

Chinese patent application CN110330434 describes a method for fabricating organic-inorganic perovskites, in which a lead source selected from lead acetate, lead oxide, or lead carbonate is mixed with hydroiodic acid, hydrobromic acid or hydrochloric acid; next isopropanol is added followed by heating the mixture to the temperature from the range of 110 to 130°C.

However, the known methods for synthesizing metal halides as well as forming perovskites from inks comprising said metal halide salts do not provide a satisfactory effect of purity of the synthesized metal halide salts, inks, powders and perovskites.

### SUMMARY

Therefore, the aim of the present disclosure is to provide a method for synthesizing metal halide salts, as well as preparing perovskite precursor inks, powders, and perovskites based on said metal halide salts that can be devoid of at least one of the above inconveniences, particularly, to minimize the presence of defects and impurities in both the metal halide salts serving as perovskite precursors as well as perovskites themselves, thereby, optimizing perovskite solar cells (PSCs) performance.

In one aspect of the present disclosure, there is provided a method for synthesizing halide salts of a Formula Me^{y+}X⁻_{y}, wherein Me^{y+} represents a cation of a metal having a valency y, and X⁻ represents an anion of a halogen (X₂). The method comprises reacting a first reactant comprising the metal at a zero oxidation degree (Me⁰) in a powder form and an organic acid (A) in a solvent (S), wherein the molar ratio of the metal (Me⁰) to the organic acid (A) is in the range of 0.1:1.0 to 2.0:1.0 with a second reactant being a diatom halogen: X₂.

The method may comprise obtaining the first reactant by preparing a mixture of components: the metal (Me⁰) in a powder form comprising particles of the metal (Me⁰), the organic acid, and the solvent, and mixing the components for 5 minutes to 24 hours whilst heating the components to the temperature from the range of 20 to 100°C.

Said reacting the first reactant with the second reactant can be carried out directly after obtaining the first reactant.

The metal (Me⁰) can be selected from the group consisting of Al, Ag, Bi, Cd, Co, Cu, Fe, Ga, Ge, Hf, Hg, Mn, Nb, Ni, Pb, Sc, Sn, Ta, Ti, Tl, V, Y, Zn, and Zr.

The cation (Me^{y+}) of the metal can be selected from the group consisting of Ag⁺, Bi³⁺, Cs⁺, Cu⁺, Ge²⁺, Mn²⁺, Pb²⁺, Sn²⁺, and Zn²⁺.

The cation (Me^{y+}) of the metal can be selected from the group consisting of Sn²⁺ and Pb²⁺.

The diatom halogen (X₂) can be selected from the group consisting of Br₂, and I₂,

The organic acid can be at least one acid selected from the group consisting of formic acid, propanoic acid, hexanoic acid, myristic acid, oxalic acid, maleic acid, tartaric acid, 1,4-cyclohexanodicarboxylic acid, sebacic acid, japanic acid, phtalic acid, isophtalic acid, terephtalic acid, 2,5-furandicarboxylic acid, tricarboxylic acid, citric acid, agaric acid, gallic acid, 1,2,3,4-butanetetracarboxylic acid, and pyromellitic acid, or any mixture of two or more thereof.

The solvent can be selected from polar protic solvents selected from water, methanol, ethanol, isopropanol, n-butanol, ethylene glycol, glycerol, or a mixture of two or more thereof being miscible to each other, or aprotic polar solvents selected from ethyl acetate, acetonitrile, dimethylformamide, dimethyl sulfoxide, dioxane, gamma-butyrolactone, tetrahydrofuran, or a mixture of two or more thereof being miscible to each other, or said nonpolar solvents selected from chloroform, chlorobenzene, toluene, or a mixture of two or more thereof being miscible to each other, and wherein the weight ratio of the metal (Me⁰) to the solvent (S) in the mixture is in the range of 2:1 to 25:1

The method may comprise, whilst reacting, heating the reactants to the temperature from the range of 20 to 100°C till obtaining a post-reaction system comprising the halide salt.

The method may further comprise obtaining a perovskite precursor in a form of ink or powder by introducing to said post-reaction system, a second component (AX) selected from the group consisting of methyl ammonium iodide (MAI), formamidinium iodide (FAI), n-octylammonium iodide (OAI), phenylethylammonium bromide (PEABr) or metal halide (MeX_{y}), such as Csl, CsBr, in an amount effective for the perovskite precursor synthesis.

The method may further comprise forming a photoactive perovskite (AMeXs) from the perovskite precursor by coating a substrate with said perovskite precursor, and annealing the perovskite precursor coat to a temperature suitable for crystalizing the photoactive perovskite (AMeXs).

In another aspect, the invention relates to a halide salt obtained by the method as described herein.

In yet another aspect, the invention relates to a perovskite precursor in a form of ink or powder, obtained by reacting the halide salt as described herein with a second reagent (AX) for the perovskite precursor synthesis.

The invention further relates to a photoactive perovskite layer (AMeX₃) prepared from the perovskite precursor as described herein.

These and other features, aspects, and advantages of the invention will become better understood with reference to the following drawings, descriptions and claims.

### BRIEF DESCRIPTION OF DRAWINGS

Aspects and features of the present invention will become apparent by describing, in detail, exemplary embodiments of the present invention with reference to the attached drawings, in which:
Fig. 1 presents schematically the method for synthesizing metal halides according to the present disclosure;
Fig. 2 presents schematically a process of preparing a first reactant for metal halide synthesis according to the present disclosure;
Fig. 3 presents schematically a method for preparing an ink or powder followed by preparing a perovskite (AMeXs), using the metal halides synthesized according to the method of the present disclosure;

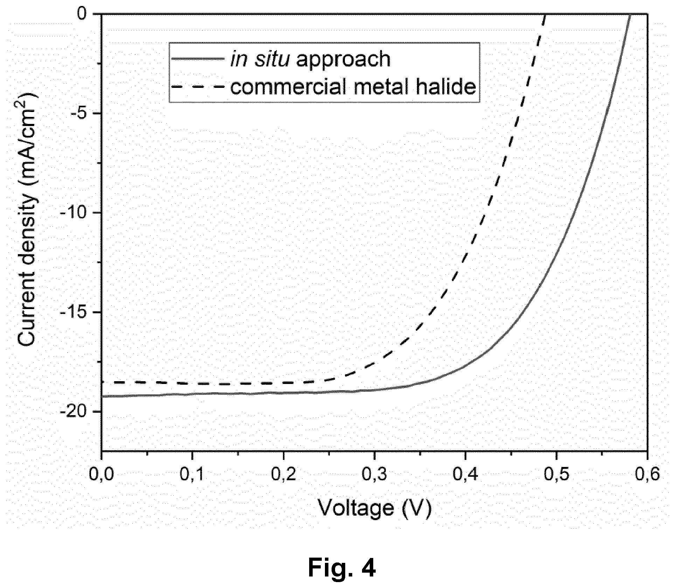

Fig. 4 shows the JV curve of solar cells with a perovskite layer made using the presented method and made using a commercial metal halide

### DETAILED DESCRIPTION OF EMBODIMENTS

Reference will now be made to embodiments, examples of which are illustrated in the accompanying drawings. Aspects and features of the embodiments will be described with reference to the accompanying drawings. The present invention, however, may be embodied in various different forms and should not be construed as being limited only to the illustrated embodiments. Rather, these embodiments are provided as examples so that this disclosure will be thorough and complete, and will fully convey the aspects and features of the present invention to those skilled in the art. It shall be understood that not all of the features shown in the embodiments are essential and the scope of the protection is defined not by means of literally shown embodiments, but by the features provided in the claims.

In one aspect, the present disclosure relates to the method for synthesizing halide salts according to Formula I:

Me^{y+}X⁻_{y} Formula I

where:
X represents a halogen anion, preferably Cl-, Br, or I; and more preferably the halogen anion selected from Brand I;
Me^{y+} represents a cation of metal having a valency y, and preferably the cation of the metal selected from the group of metals consisting of Al, Ag, Bi, Cd, Co, Cu, Fe, Ga, Ge, Hf, Hg, Mn, Nb, Ni, Pb, Sc, Sn, Ta, Ti, Tl, V, Y, Zn, Zr; more preferably M^{y+} represents the cation selected from the group consisting of Ag⁺, Bi³⁺, Cs⁺, Cu⁺, Ge²⁺, Mn²⁺, Pb²⁺, Sn²⁺, and Zn²⁺; and even more preferably Me^{y+} represents the cation selected from the group consisting of Sn²⁺ and Pb²⁺.

The method for synthesizing halide salts (MeX_{y}) according to the present disclosure involves reacting a first reactant prepared from a mixture of metal at zero oxidation state (Me⁰),an organic acid, and a solvent being an organic solvent or inorganic solvent, or a mixture of organic and inorganic solvent, with a second reactant being a diatom halogen: X₂ Cl₂, Br₂ or I₂, and preferably selected from Br₂ and I₂.

### Preparation of the first reactant

Preparation of the first reactant comprises the step of providing metal at zero oxidation degree (Me⁰) in a powder form. The powder form preferably comprises particles of Me⁰ having the particle size of 50 nm to 200 µm, and more preferably the particles of Me⁰ having the particle size of 500 nm to 200 µm, and most preferably particles of Me⁰ having the particle size of 1 µm to 200 µm. In a single mixture for the first reactant, the particular particles of Me⁰ can have exactly or substantially exactly the same particle size, or the particular particles of Me⁰ can vary in particle size, falling in the above-mentioned particle size range.

The particles of Me⁰ are mixed with both the organic acid and the solvent, thereby obtaining the mixture for the first reactant. The order of adding the organic acid and the solvent does not influence the reaction carried out subsequently. The particles of Me⁰ can be first mixed with the solvent followed by adding the organic acid, thus obtaining the mixture. Optionally, the particles of Me⁰ can be mixed firstly with the organic acid followed by introducing the solvent, thus obtaining the mixture. Further, optionally, the particles of Me⁰ can be suspended or dispersed in the solvent followed by adding the organic acid. Alternatively, the solvent and the organic acid can be mixed with the particles of Me⁰ simultaneously. The particles of Me⁰ are mixed with the organic acid (A) in the amount to obtain the molar ratio of Me⁰:A of 0.1:1.0 to 2.0:1.0, in the mixture. The amount of the solvent in the mixture can vary. The preferred amount of solvent, in the mixture, is that enabling for mixing the particles of Me⁰ with the organic acid. Substantially greater amounts of the solvent can be present in the mixture, however, this may slow the subsequent reaction of the first and second reactants. Thus, greater amounts of the solvent can be provided in the mixture, if a slower rate of the reaction is intended. For example, the weight ratio of solvent (S): halogen (X₂) in the mixture preferably amounts from 2:1 to 25:1.

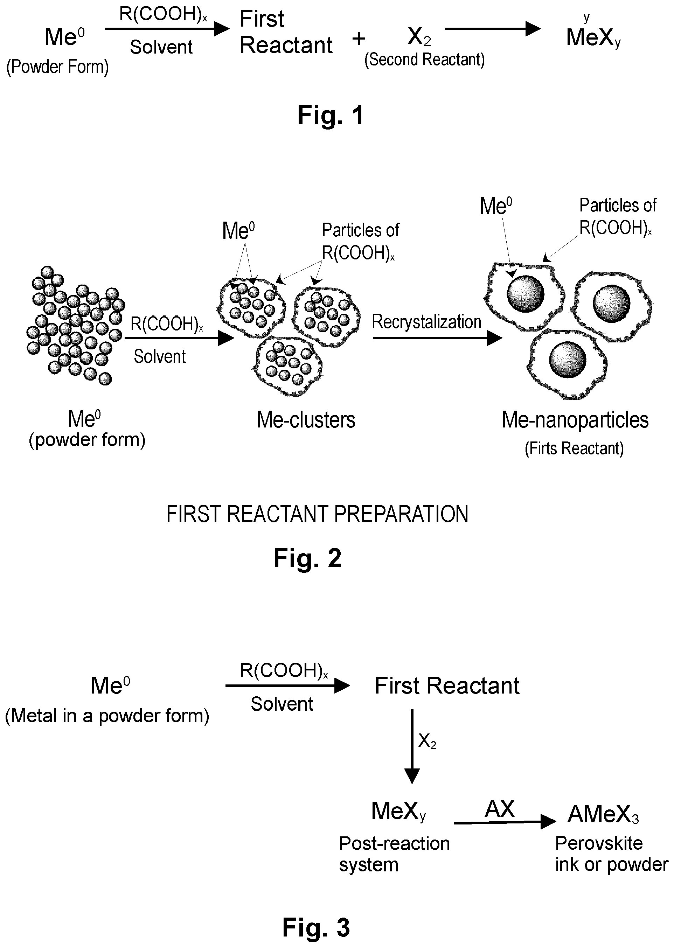

The prepared mixture, comprising the particles of Me⁰, the organic acid, and the solvent, is subjected to stirring preferably for 5 minutes to 24 hours, whilst stirring the temperature of the mixture is maintained in the range of 20 to 100°C. As schematically depicted in Fig 2, it is believed that, in these conditions, the particles of Me⁰ forms clusters that are surrounded by the organic acid (`Me-clusters'), in which the particles of Me⁰ are subjected to recrystallization, thereby, transforming into particles of Me⁰ of nanosized dimensions ('Me-nanopoarticles') - being the first reactant.

### Particles of Me⁰

Preferably, the single mixture for the single first reactant comprises a single type of metal (Me⁰), thus the particles of Me⁰ are made of a single metal (Me⁰), preferably the metal (Me⁰) selected from alkali metals, and alkaline earth metals. More preferably, the particles of Me⁰ are made of the metal (Me⁰) selected from the group consisting of Al, Ag, Bi, Cd, Co, Cu, Fe, Ga, Ge, Hf, Hg, Mn, Nb, Ni, Pb, Sc, Sn, Ta, Ti, Tl, V, Y, Zn, and Zr; and even more preferably, the particles of Me⁰ are made of the metal (Me⁰) selected from the group consisting of Ag, Bi, Cs, Cu, Ge, Mn, Pb, Sn, and Zn, wherein the most preferably the particles of Me⁰ are made of the metal (Me⁰) selected from Sn and Pb.

Optionally, if desired, the mixture may comprise two or more than two types of particles of Me⁰, wherein each type defines the particles of Me⁰ made of different metal (Me⁰) selected from the above-listed alkali metals, and alkaline earth metals. Thereby, in the single mixture, the particles of Me⁰ may differ from each other by the metal (Me⁰) type they are made of.

### Organic Acid

The organic acid for the mixture can constitute a single organic acid or a mixture composed of two or more than two component organic acids that are miscible with each other. The organic acid for the mixture, is selected from monocarboxylic acid(s) and polycarboxylic acid(s), represented by general Formula II:

R(COOH)ₓ Formula II

where:
x denotes the number of -COOH moieties, wherein x is natural number from 1 to 4;
R represents
   hydrogen (-H) or carboxyl group (-COOH), for x=1, or
   another organic moiety (different from -COOH), for x ≥1, preferably the organic moiety being hydrocarbon C₁-C₂₆, in which one or more than one carbon atom can be optionally independently substituted by phosphorus, silicon, oxygen, nitrogen, or sulphur, and/or one or more than one hydrogen atom can be optionally independently substituted by iodine, chlorine, bromine, and fluorine.

Preferably, the R substituent is selected from -H, -COOH, C₁-C₁₆ alkyl, C₆ aryl or C₁₀ aryl, C₇₋₂₆ aralkyl, or heterocycle moiety (Hm), wherein:
C₁-C₁₆ alkyl constitutes acyclic, straight or branched hydrocarbon chain comprising from 1 to 16 carbon atoms in the chain, optionally comprising at least one heteroatom substituting the carbon atom or hydrogen atom in the C₁-C₁₆ alkyl moiety, wherein the heteroatom being selected from the group consisting of phosphorus, silicon, oxygen, nitrogen, sulphur, iodine, chlorine, bromine, and fluorine;
C₆ aryl or C₁₀ aryl constituting an aromatic monocyclic system comprising six carbon atoms forming the ring system, or an aromatic bicyclic system comprising ten carbon atoms forming the bicyclic system, optionally comprising at least one heteroatom substituting the carbon atom or hydrogen atom in the C₆ aryl or C₁₀ aryl moiety, wherein the heteroatom is selected from the group consisting of oxygen, nitrogen, sulphur;
heterocycle moiety (Hm) constituting monovalent substituent derived by removing hydrogen from a five-, six-, or seven-membered saturated or unsaturated alicyclic moiety or aromatic heterocycle moiety, comprising carbon atoms and from one to four ring heteroatoms selected from nitrogen, oxygen, and sulfur;
C₇₋₂₆ aralkyl constituting the C₆ arkyl or C₁₀ aryl substituent linked to the nitrogen atom of the organic cation through the C₁-C₁₆ alkyl, optionally comprising at least one heteroatom substituting the carbon atom or hydrogen atom, wherein the heteroatom is selected from the group consisting of: phosphorus, silicon, oxygen, nitrogen, sulphur, iodine, chlorine, bromine and fluorine; and heterocycle substituent constituting monovalent substituent derived by removing hydrogen from a five-, six-, or seven-membered saturated or unsaturated alicyclic moiety or aromatic heterocycle moiety, comprising carbon atoms and from one to four ring heteroatoms selected from nitrogen, oxygen, and sulfur.

Non-limiting examples of the organic acid (R(COOH)ₓ) that can be used according to the present disclosure include:
monocarboxylic acid R¹COOH, wherein R¹ represents H or saturated aliphatic hydrocarbon C₁-C₂₆, such as for example: formic acid, propanoic acid, hexanoic acid, myristic acid ;
dicarboxylic acid H₂OOC-COOH₂, or R²(COOH)₂ wherein R² represents saturated aliphatic hydrocarbon C₂-C₂₆; such as for example: oxalic acid, maleic acid, tartaric acid, 1,4-cyclohexanodicarboxylic acid, sebacic acid, japanic acid;
tricarboxylic acid R³(COOH)₃ wherein R³ represents saturated aliphatic hydrocarbon C₆-C₂₆; such as from example: citric acid, agaric acid;
tetracarboxylic acid R⁴(COOH)₄ wherein R⁴ represents saturated aliphatic hydrocarbon C₈-C₂₆; such as from example: 1,2,3,4-butanetetracarboxylic acid;
dicarboxylic acid represented by general Formula III: 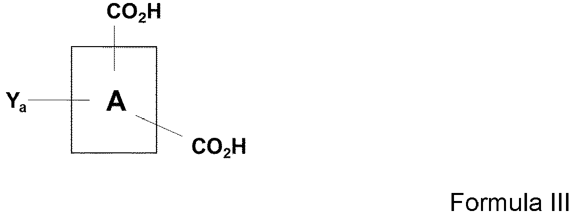 where:
   A represents five-membered or six-membered aliphatic or aromatic hydrocarbon ring, optionally having at least one heteroatom substituting the carbon atom selected from oxygen, nitrogen, and sulphur;
   Y represents a substituent of the ring A other than hydrogen;
   a - denotes the number of Y moieties, wherein a is zero or an integer in the range of 1 to 4 if A represents the five-membered ring, or a is zero or an integer in the range of 1 to 5 if A represents the six-membered ring;
the non-limiting examples of dicarboxylic acid according to Formula III are as follows: phtalic acid, isophtalic acid, terephtalic acid, 2,5-furandicarboxylic acid;
tricarboxylic acid represented by general Formula IV: 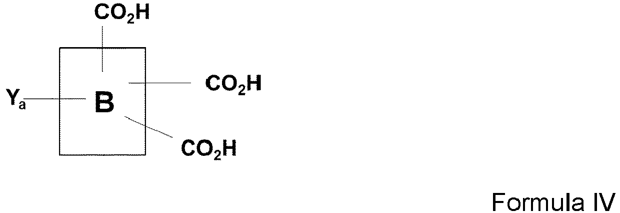 where:
   B represents five-membered or six-membered aliphatic or aromatic hydrocarbon ring, optionally having at least one heteroatom substituting the carbon atom selected from oxygen, nitrogen, and sulphur;
   Y represents a substituent of the ring B other than hydrogen;
   a denotes the number of Y moieties, wherein a is zero or an integer in the range of 1 to 4 if B represents the five-membered ring, or a is zero or an integer in the range of 1 to 5 if B represents the six-membered ring;
the non-limiting example of tricarboxylic acid according to Formula IV is gallic acid;
tetracarboxylic acid represented by general Formula V: 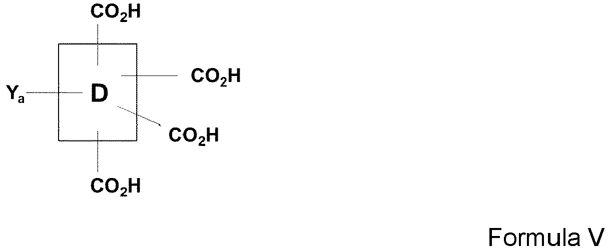 where:
   D represents five-membered or six-membered aliphatic or aromatic hydrocarbon ring, optionally having at least one heteroatom substituting the carbon atom selected from oxygen, nitrogen, and sulphur;
   Y represents a substituent of the ring D other than hydrogen;
   a denotes the number of Y moieties, wherein a is zero or an integer in the range of 1 to 4 if D represents the five-membered ring, or a is zero or an integer in the range of 1 to 5 if D represents the six-membered ring;
the non-limiting example of tetracarboxylic acid according to Formula V is pyromellitic acid.

### Solvent

The solvent for the mixture can constitute a single solvent or a mixture composed of two or more than two component solvents that are miscible with each other. The solvent for the mixture is selected from polar protic solvent(s), aprotic polar solvent(s), and nonpolar solvent(s).

The non-limiting examples of said polar protic solvents include water, and alcohols including monohydric alcohol and polyols, for example, methanol, ethanol including but not limited to ethanol/water azeotropic mixture, and substantially 100% ethanol (e.g. obtained by distillation of water-ethanol mixture with an addition of benzene used in amount for azeotrope breakup), isopropanol, n-butanol, ethylene glycol and glycerol, and a mixture of two or more of the above mentioned polar protic solvents.

The non-limiting examples of said aprotic polar solvents include ethyl acetate, acetonitrile, dimethylformamide, N-methylpyrrolidone, dimethyl sulfoxide, dioxane, gamma-butyrolactone, tetrahydrofuran, and a mixture of two or more of the above mentioned aprotic polar solvents.

The non-limiting examples of said nonpolar solvents include chloroform, chlorobenzene, toluene, and a mixture thereof.

### Synthesis of halide salts

As shown in Fig 1, following the preparation of the first reactant, the first reactant is brought into contact with the second reactant: the diatom halogen (X₂). Preferably the first reactant and the second reactant are brought into contact directly after preparing the first reactant, and more preferably the second reactant is directly introduced into the vessel in which the first reactant has been prepared - as explained above, to avoid further contamination of the reactants from external sources. The latter allows the halide salts to be synthesized *in situ* - at the place of preparation of the first reactant.

The molar proportion of the two reactants is selected so as to provide the molar ratio of Me⁰ : X₂ in the range of 1.0:1.0 to 4.0:1.0. The halide salt synthesis is carried out preferably for 5 minutes to 24 hours, maintaining the temperature of the reactants between 0 and 100°C, preferably under constant mixing or agitating the reactants.

Once the diatom halogen (X₂) is brought into contact with the metal (Me⁰) comprised in the first reactant, the halide salt synthesis starts. This involves a redox reaction with a substantially fast reaction course. The metal Me⁰ in a form of Me-nanoparticles - as explained above (Fig. 2) can react substantially smoothly with the diatom halogen (X₂) yielding the metal halide of improved purity. No side reactions have been spotted, and no by-products have been detected during the synthesis according to the present disclosure.

Depending on the needs, the obtained metal halide (MeX_{y}) can be isolated from a post-reaction system, for example by removing the post-reaction media. For instance, under reduced pressure the solvent, and - if desired - the carboxylic acid can be removed from the post-reaction system, thereby, obtaining isolated halide salt that can be used e.g. as a precursor in another synthesis. Otherwise, the post-reaction system containing the synthesized halide salt can be used as a whole (without purifying the halide salt) for further synthesis, e.g., to prepare perovskite precursors in a form of ink or perovskite polycrystalline powder.

### Ink and powder preparation

As explained above, the post-reaction system comprises the solvent and the organic acid that were introduced into the reaction system as the components of the first reactant; also the post-reaction system comprises the synthesized halide salt MeX_{y} being the reaction product. Depending on the amounts of the particles of Me⁰, the organic acid and the solvent used for the preparation of the first reactant, the post-reaction system can comprise e.g. from 50 mmol per liter to 2000 mmol per liter of the synthesized halide salt (MeX_{y}).

Depending on the solvent and the organic acid used, the post-reaction system can be used directly - without any further purification of treatment steps, as a precursor for *in situ* preparation of the ink - being a direct perovskite precursor or to obtain perovskite polycrystalline powder, as shown schematically in Fig. 3. Non-limiting examples of the solvent and the organic acid that allow for said direct use of the post-reaction system to prepare said ink or powder, include: isopropanol, acetonitrile, dimethylformamide, N-methylpyrrolidone, dimethyl sulfoxide, dioxane, gamma-butyrolactone, and tetrahydrofuran.

The method for *in situ* perovskite ink or powder preparation, where the ink or powder can serve as perovskite precursor, can involve introducing a second component (AX) into the post-reaction system (Fig. 3), in an amount effective for perovskite precursor preparation, for example, the stoichiometric amount can be used. For example, the second component (AX) can be selected from organohalides, such as alkylammonium halides, e.g. methyl ammonium iodide (MAI), formamidinium iodide (FAI), n-octylammonium iodide (OAI), phenylethylammonium bromide (PEABr) or metal halides, such as form example: Csl, CsBr.

Preferably, the second component (AX) is in a solid state, and more preferably in a form of powder. Preferably the second component (AX) is of high purity. This further reduces introducing various impurities into the perovskite precursor system. This way one can avoid further contamination of the ink or powder. In this case, the ink or powder is prepared *in situ* - at the place of preparation of the metal halide salt ingredient.

Said *in situ* preparation of the ink or powder i.e., at the place of the metal halide salt synthesis (preferably literally in the same vessel), can be particularly favorable when using metal halide salts such as SnX₂, e.g. SnI₂, SnBr₂, i.e. comprising easily oxidizable metal, e.g. Sn²⁺ which is known to easily transform into Sn⁴⁺, during treatment or handling of tin(II) halide salt, e.g. purification.

Thereby, one aspect of the method according to the present disclosure is the use of elemental halides (X₂) and metals at zero oxidation degree (Me⁰) such that the first reactant and the second reactant can show improved purity. Further, due to the simple composition of the obtained post-reaction system, preparation of the ink (serving as a perovskite precursor) or powder can be carried out *in situ* - at the place of metal halide synthesis, no further isolation or purification steps of the obtained metal halide salt is needed since all the post-reaction components can become the ink components or powder. Thereby the risk of further contamination of the perovskite precursors obtained therefrom, is reduced. Furthermore, notwithstanding the above, the metal halides, inks and powders based on the synthesized metal halide salts, in particular, the inks or powders prepared based on said post-reaction system, show a considerably diminished tendency to generate impurities therewithin. Therefore, the level of impurities in the perovskite precursors - prepared according to the present disclosure, originating from both external sources and intrinsically generated, is considerably decreased.

According to the present disclosure, the perovskite ink or powder can be for example prepared from the post-reaction system comprising: SnI₂, SnBr₂, PbI₂, PbBr₂ - as the halide salt, and isopropanol, acetonitrile, dimethylformamide, N-methylpyrrolidone, dimethyl sulfoxide, dioxane, gamma-butyrolactone, or tetrahydrofuran or a mixture of two or more thereof - as the solvent, and formic acid, acetic acid, oxalic acid, succinic acid, sebacic acid, glycine benzoic acid, 2,5-thiophenedicarboxylic acid or a mixture thereof - as the organic acid, whereas the second component (AX) can be selected from MAI or FAI or a mixture thereof. Preparing the ink or powder can involve mixing the post-reaction system with the second component (AX), in an amount suitable for perovskite precursor formation.

Exemplary non-limiting ink systems that can be prepared according to the method of the present disclosure, are presented in Table 1.

### Perovskite layer preparation

Preparation of the perovskite layers from the inks described above can involve depositing the ink on a suitable substrate (rigid or flex substrate coated with transparent conductive oxide, eg. indium-doped tin oxide (ITO), fluorine-doped tin oxide (FTO) zinc-doped indium oxide (IZO)), between charge transport layers and the top electrode. The ink can be applied on the substrate forming 100 to 1000 nm thick and substantially even ink coating. Said coating can be prepared using various suitable coating methods, such as spin coating, blade-coating, slot-die coating, or ink-jet printing. Next, the ink coating is heated till obtaining perovskite photoactive structure on the substrate. Exemplary non-limiting perovskites that can be prepared according to the method of the present disclosures are provided in Table 1.

**Table 1 - exemplary ink systems and perovskite preparation conditions according to the present disclosure:**

| Composition | Post-reaction System [ composition] | Second Component | Ink Composition | Perovskite preparation |
|---|---|---|---|---|
| Example 1 | 0.8M of SnI₂ | 137.6 mg of FAI | 0.8M FASnI₃ in DMF/DMSO 4:1 (v/v) | Deposited ink annealed at 100°C for 10 min |
| | 1 ml DMF/DMSO | | | |
| | 4:1 (v/v); | | | |
| | Organic acid: acetic acid 100 µL¹ | | | |
| Example 2 | 0.8M of SnI₂ | 137.6 mg of FAI | 0.8M FASnI₃ in DMF/DMSO 4:1 (v/v) | Deposited ink annealed at |
| | 1 ml DMF/DMSO | | | |
| | 4:1 (v/v) | 12.5 mg of SnF₂ | | |
| | Organic acid: | | | |
| | oxalic acid | | | 100°C for 10 min |
| | 150 mg¹ | | | |
| Example 3 | 1.0M of SnI₂ | 154.8 mg of FAI | 1.0M FA_{0.9}PEA_{0.1}SnI₃ in DMF/DMSO 4:1 (v/v) | Deposited ink annealed at 60°C for 10 min, then 90 for 10 min |
| | 1 ml DMF/DMSO | | | |
| | 4:1 (v/v) | PEAl of 24.9 mg 15.7 mg of SnF₂ | | |
| | Organic acid: acetic acid | | | |
| | 20 µL¹ | | | |
| Example 4 | 1.2M of PbI₂ | 190.8 mg of MAI | 1.2M MAPbI₃ in DMF/DMSO 9:1 (v/v) | Deposited ink annealed at 100°C for 30 min |
| | 1 ml DMF/DMSO | | | |
| | 9:1 (v/v) | | | |
| | Organic acid: 2,5-thiophenedicarboxylic acid 9 mg¹ | | | |
| Example 5 | 1.0M of PbI₂ | 344.0 mg of FAI | 1.0M FAPb_{0.5}Sn_{0.5}I₃ in DMF/DMSO 3:1 (v/v) | Deposited ink annealed at 100°C for 15 min |
| | 1.0M of SnI₂ | | | |
| | 2 ml DMF/DMSO | | | |
| | 3:1 (v/v) | 31.3 mg of SnF₂ | | |
| | thiophenedicarboxylic acid 9 mg¹ | | | |

| | | | | |
|---|---|---|---|---|
| ¹ amount of the organic acid used for preparing the first reactant (the organic acid was not removed from the post reaction system); | | | | |

The metal halides as well as inks and powders comprising said perovskite precursors can be further used for producing various optoelectronic devices, such as photovoltaic cells or light emitting diodes (LEDs) comprising a photoactive layer made of perovskites prepared according to the present disclosure.

The metal halides synthesized according to the present disclosure as well as inks, powders and perovskites prepared therefrom exhibit improved purity (having no or reduced amount of impurities). Therefore, the lifespan and efficiency of the perovskite photoactive materials based on the metal halides synthesized according to the present disclosure are improved. This is especially noticeable for the tin(II) halides (SnX₂) such as SnI₂, SnBr₂, synthesized according to the presented method, since standard compounds of tin(II) - synthesized according to standard methods, are prone to contamination with Sn⁴⁺ (being the product of Sn²⁺ oxidation). Unlike the standard tin(II) halides, the tin(II) halides prepared according to the present disclosure lack or have a reduced amount of Sn⁴⁺ compared to conventional synthesis or commercially available ones. Preferably, the same applies to inks, powders and perovskites prepared therefrom - which have shown no or considerably reduced concentration of Sn⁴⁺ ions. Said effect pertains to the tin(II) halides as well as said inks and powders without any further purification or additional treatment. The metal halides serving as the perovskite precursors can show substantially improved purity, whereas said purity can be maintained at a constant level within one production batch and from one batch to another. This enables one to achieve minor or no differences in photovoltaic efficiency of the PCSs comprising the perovskites based on inks or powders according to the present disclosure, leading to increased device reproducibility, and therefore reliable quality.

Furthermore, the perovskites based on the tin(II) halides, prepared according to the presented method, allow the photovoltaic devices (based on said perovskites) to achieve significantly increased PCE (Power Conversion Efficiency), when compared with perovskites based on SnX₂ synthesized conventionally.

Therefore, some of the preferred products according to the present disclosure are tin(II) halides synthesized by the method described therein, and the inks or powders comprising said tin(II) halides.

### EMBODIMENT 1 - synthesis of lead(II) iodide:

5 g of lead powder was suspended in 20 mL of n-butanol. Subsequently, 100 µL of acetic acid was added, resulting in a greyish-dense dispersion. The dispersion was stirred for 4 hours. The 5.08 g of iodine was added gradually to the dispersion under vigorous stirring. The mixture was further agitated for 8 hours at 60°C. The obtained lead(II) iodide was precipitated and then collected (8.91 g, 87% yield).

### EMBODIMENT 2 - synthesis of tin(II) iodide:

Under a nitrogen atmosphere, 2.05 g of tin powder was suspended in 15 mL of ethyl acetate. Subsequently, 150 mg of oxalic acid was added, resulting in a greyish-dense dispersion. The dispersion was stirred for 2 hours. The 3.80 g of iodine was added gradually to the dispersion under vigorous stirring. The mixture was further agitated for 8 hours at 50°C. The tin(II) iodide was precipitated and then collected (5.14 g, 92% yield).

### EMBODIMENT 3 - preparation of methylammonium lead triiodide in situ from lead:

556 mg of lead powder was suspended in 2 mL of DMF:DMSO 9:1 (v/v). Subsequently, 20 µL of acetic acid was added, resulting in a greyish-dense dispersion. The dispersion was stirred for 4 hours. The 508 mg of iodine was added gradually to the dispersion under vigorous stirring. The mixture was further agitated for 8 hours and 1.0M PbI₂ solution was obtained. To lead(II) iodide solution was added 31.79 mg of MAI and stirred overnight. The obtained perovskite ink was ready for processing.

### EMBODIMENT 4 - preparation of formamidinium tin triiodide in situ from tin:

Under a nitrogen atmosphere, 165 mg of tin powder was suspended in 2 mL of DMF:DMSO 4:1 (v/v). Subsequently, 9 mg of 2,5-thiophenedicarboxylic acid was added, resulting in a greyish-dense dispersion. The dispersion was stirred for 4 hours. The 305 mg of iodine was added gradually to the dispersion under vigorous stirring. The mixture was further agitated for 8 hours and 0.6M SnI₂ solution was obtained. To tin(II) iodide solution was added 206.36 mg of FAI and stirred overnight. The obtained perovskite ink was ready for processing.

### EMBODIMENT 5 - preparation of FASI perovskite from in situ approach:

Under a nitrogen atmosphere, 165 mg of tin powder was suspended in 2 mL of DMF:DMSO 4:1 (v/v). Subsequently, 9 mg of 2,5-thiophenedicarboxylic acid was added, resulting in a greyish-dense dispersion. The dispersion was stirred for 4 hours. The 305 mg of iodine was added gradually to the dispersion under vigorous stirring. The mixture was further agitated for 8 hours and 0.6M SnI₂ solution was obtained. 206.36 mg of FAI was added to tin(II) iodide solution and stirred overnight. Perovskite ink was filtered by a 0.22 µm PTFE filter and then spin-coated on the substrate at 6000 rpm for 30 s with a ramping rate of 2000 rpm·s⁻¹. Toluene was dropped onto the surface during the spin-coating process. The resulting film was annealed at 100 °C for 10 min. The perovskite layer was confirmed by XRD measurement, from profilometer determined layer thickness - 250 nm.

### EMBODIMENT 6 - preparation of MAPI perovskite polycrystalline powder:

Polycrystalline perovskite powders were synthesized by grinding of precursors in an electric ball mill (Fritsch Pulverisette 7, agate grinding jar with a volume of 25 mL and 10 agate balls, diameter size 2 mm) for 30 min at 25 Hz. Reagents were packed into the jar inside a glove box under argon. The obtained lead(II) iodide from embodiment 1 was fixed at the molar ratio for MAI:PbI2 at 1:1 and were milled to prepare MAPI perovskite.

### EMBODIMENT 7 - preparation of a perovskite solar cell

Perovskite solar cell was fabricated on flexible polyethylene terephthalate (PET) foil. IZO-coated PET substrate was etched by dipping one side in the HCl solution (15 wt% in deionized water) and then cleaned by ultrasonication in deionized water and isopropanol for 10 minutes in each solvent and dried by nitrogen flow. After that, the substrate was treated with oxygen plasma for 30 seconds and transferred to a glovebox. The hole transport layer was deposited by spin-coating 50 µL of PEDOT:PSS dispersion at 4000 rpm for 40 s, followed by annealing at 120°C for 30 minutes. The perovskite film was deposited as mentioned in Embodiment 5. Then 30 nm of fullerene C60 and 6 nm of BCP were sequentially evaporated on the perovskite layer. Finally, 100 nm of the silver electrode was deposited on the device by thermal evaporation.

While the invention has been described with respect to a limited number of embodiments, it will be appreciated that many variations, modifications, and other applications of the invention may be made. Therefore, the claimed invention, as recited in the claims that follow is not limited to the embodiments described herein.

## Claims

1. A method for synthesizing halide salts of a general Formula (I)
Me^{y+}X⁻_{y} Formula (I)
wherein:
Me^{y+} represents a cation of a metal having a valency y,
X- represents an anion of a halogen (X₂),
the method comprising reacting:
a first reactant comprising the metal at a zero oxidation degree (Me⁰) in a powder form and an organic acid (A) in a solvent (S), wherein the molar ratio of the metal (Me⁰) to the organic acid (A) is in the range of 0.1:1.0 to 2.0:1.0
with
a second reactant being a diatom halogen: X₂.

2. The method according to claim 1, comprising obtaining the first reactant by preparing a mixture of components:
the metal (Me⁰) in a powder form comprising particles of the metal (Me⁰),
the organic acid, and
the solvent,
and mixing the components for 5 minutes to 24 hours whilst heating the components to the temperature from the range of 20 to 100°C.

3. The method according to claim 2, wherein said reacting the first reactant with the second reactant is carried out directly after obtaining the first reactant.

4. The method according to any of the preceding claims, wherein the metal (Me⁰) is selected from the group consisting of Al, Ag, Bi, Cd, Co, Cu, Fe, Ga, Ge, Hf, Hg, Mn, Nb, Ni, Pb, Sc, Sn, Ta, Ti, Tl, V, Y, Zn, and Zr.

5. The method according to any of the preceding claims, wherein the cation (Me^{y+}) of the metal is selected from the group consisting of Ag⁺, Bi³⁺, Cs⁺, Cu⁺, Ge²⁺, Mn²⁺, Pb²⁺, Sn²⁺, and Zn²⁺.

6. The method according to any of the preceding claims, wherein the cation (Me^{y+}) of the metal is selected from the group consisting of Sn²⁺ and Pb²⁺.

7. The method according to any of the preceding claims, wherein the diatom halogen (X₂) is selected from the group consisting of Br₂, and I₂,

8. The method according to any of the preceding claims, wherein the organic acid is at least one acid selected from the group consisting of formic acid, propanoic acid, hexanoic acid, myristic acid, oxalic acid, maleic acid, tartaric acid, 1,4-cyclohexanodicarboxylic acid, sebacic acid, japanic acid, phtalic acid, isophtalic acid, terephtalic acid, 2,5-furandicarboxylic acid, tricarboxylic acid, citric acid, agaric acid, gallic acid, 1,2,3,4-butanetetracarboxylic acid, and pyromellitic acid, or any mixture of two or more thereof.

9. The method according to any of the preceding claims, wherein the solvent is selected from
polar protic solvents selected from water, methanol, ethanol, isopropanol, n-butanol, ethylene glycol, glycerol, or a mixture of two or more thereof being miscible to each other, or
aprotic polar solvents selected from ethyl acetate, acetonitrile, dimethylformamide, dimethyl sulfoxide, dioxane, gamma-butyrolactone, tetrahydrofuran, or a mixture of two or more thereof being miscible to each other, or
said nonpolar solvents selected from chloroform, chlorobenzene, toluene, or a mixture of two or more thereof being miscible to each other,
and wherein the weight ratio of the metal (Me⁰) to the solvent (S) in the mixture is in the range of 2:1 to 25:1

10. The method according to any of the preceding claims, comprising, whilst reacting, heating the reactants to the temperature from the range of 20 to 100°C till obtaining a post-reaction system comprising the halide salt.

11. The method according to claim 10, further comprising obtaining a perovskite precursor in a form of ink or powder by introducing to said post-reaction system, a second component (AX) selected from the group consisting of methyl ammonium iodide (MAI), formamidinium iodide (FAI), n-octylammonium iodide (OAI), phenylethylammonium bromide (PEABr) or metal halide (MeX_{y}), such as Csl, CsBr, in an amount effective for the perovskite precursor synthesis.

12. The method according to claim 11, further comprising forming a photoactive perovskite (AMeXs) from the perovskite precursor by coating a substrate with said perovskite precursor, and annealing the perovskite precursor coat to a temperature suitable for crystalizing the photoactive perovskite (AMeX₃).

13. A halide salt obtained by the method according to any of the claims from 1 to 10.

14. A perovskite precursor in a form of ink or powder, obtained by reacting the halide salt according to claim 13 with a second reagent (AX) for the perovskite precursor synthesis.

15. A photoactive perovskite layer (AMeX₃) prepared from the perovskite precursor according to claim 14.
